# EUROPEAN PATENT APPLICATION

(11) **EP 4 734 111 A1**
(43) Date of publication of application: **29.04.2026**
(21) Application number: 25171924.1
(22) Date of filing: 23.04.2025
(51) Int. Cl.: G11C 5/02, G11C 5/14, H01L 23/50, H01L 25/065

(54) **SEMICONDUCTOR MEMORY PACKAGE**

(30) Priority: 23.10.2024 KR 20240145657
(71) Applicant: Samsung Electronics Co., Ltd., Suwon-si, Gyeonggi-do 16677 (KR)
(72) Inventor: LEE, Yeonjin, Suwon-si, Gyeonggi-do 16677 (KR); CHOI, Junghwan, Suwon-si, Gyeonggi-do 16677 (KR); PARK, Keonhee, Suwon-si, Gyeonggi-do 16677 (KR); JEONG, Haewook, Suwon-si, Gyeonggi-do 16677 (KR)
(74) Representative: Kuhnen & Wacker Patent- und Rechtsanwaltsbüro PartG mbB

(57) **Abstract**

Provided is a semiconductor memory package including: a buffer semiconductor die including an interface circuit configured to perform communication with a memory controller; a plurality of core semiconductor dies stacked in a vertical direction on the buffer semiconductor die, wherein a core semiconductor die of the plurality of core semiconductor dies includes a semiconductor memory device; and a heterogeneous semiconductor die stacked with the buffer semiconductor die and the plurality of core semiconductor dies, wherein the heterogeneous semiconductor die includes: a capacitor array including a plurality of power capacitors; and an electrode conductor connecting electrodes of the plurality of power capacitors.

## Description

### BACKGROUND

### 1. Field

The disclosure generally relates to semiconductor integrated circuits, and more particularly to a semiconductor package including a plurality of semiconductor dies or a plurality of semiconductor chips that are stacked in a vertical direction.

### 2. Description of the Related Art

Recently, the electronics market has seen a rapid increase in the demand for portable devices, which has led to miniaturization and weight reduction of electronic components, such as semiconductor memory devices mounted in portable devices. To realize miniaturization and weight reduction of semiconductor memory devices, the individual size of the mounting components is reduced. However, this process may result in a degradation of electrical characteristics.

### SUMMARY

Provided is a semiconductor memory package having enhanced electrical characteristics.

According to an embodiment of the disclosure, a semiconductor memory package includes: a buffer semiconductor die including an interface circuit configured to perform communication with a memory controller; a plurality of core semiconductor dies stacked in a vertical direction on the buffer semiconductor die, wherein a core semiconductor die of the plurality of core semiconductor dies includes a semiconductor memory device; and a heterogeneous semiconductor die stacked with the buffer semiconductor die and the plurality of core semiconductor dies, wherein the heterogeneous semiconductor die includes: a capacitor array including a plurality of power capacitors; and an electrode conductor connecting electrodes of the plurality of power capacitors.

According to an aspect of the disclosure, a semiconductor memory package includes: a buffer semiconductor die including an interface circuit configured to perform communication with a memory controller; a plurality of core semiconductor dies stacked in a vertical direction on the buffer semiconductor die, wherein a core semiconductor die of the plurality of core semiconductor dies includes a semiconductor memory device; and a heterogeneous semiconductor die stacked with the buffer semiconductor die and the plurality of core semiconductor dies, wherein the heterogeneous semiconductor die includes: a plurality of power capacitors; a power electrode conductor connected to a power node configured to provide a power supply voltage to the buffer semiconductor die and to the plurality of core semiconductor dies, wherein the power electrode conductor connects first capacitor electrodes of the plurality of power capacitors to each other; a ground electrode conductor connected to a ground node configured to provide a ground voltage to the buffer semiconductor die and to the plurality of core semiconductor dies, wherein the ground electrode conductor connects second capacitor electrodes of the plurality of power capacitors to each other; and a monitoring circuit configured to measure at least one of an internal temperature of the semiconductor memory package and an internal voltage of the semiconductor memory package.

According to an aspect of the disclosure, a semiconductor memory package includes: a buffer semiconductor die; a plurality of core semiconductor dies; and a heterogeneous semiconductor die, wherein the buffer semiconductor die, the plurality of core semiconductor dies, and the heterogeneous semiconductor die are stacked in a vertical direction, and wherein the heterogeneous semiconductor die includes: a capacitor array connected to a power node configured to provide a power supply voltage to the buffer semiconductor die and to the plurality of core semiconductor dies and configured to increase a capacitance of the power node.

The semiconductor memory package according to one or more embodiments of the present disclosure may increase the capacitance of the voltage node and efficiently improve the voltage characteristics of the semiconductor memory package without increasing the occupied area of the semiconductor memory package by stacking the heterogeneous semiconductor die including the plurality of power capacitors together with the core semiconductor dies and by connecting the plurality of power capacitors to the voltage node.

### BRIEF DESCRIPTION OF DRAWINGS

The above and other aspects and features of certain embodiments of the present disclosure will be more apparent from the following description taken in conjunction with the accompanying drawings, in which:
FIG. 1 is a cross-sectional view illustrating a vertical structure of a semiconductor memory package according to one or more embodiments;
FIG. 2 is a schematic diagram illustrating an example embodiment of a heterogeneous semiconductor die included in a semiconductor memory package according to one or more embodiments;
FIG. 3 is a perspective view illustrating an example embodiment of a capacitor array included in the heterogeneous semiconductor die of FIG. 2;
FIG. 4 is a block diagram illustrating a memory system according to one or more embodiments;
FIG. 5 is a block diagram illustrating a semiconductor memory device according to one or more embodiments;
FIG. 6 is a diagram illustrating an example embodiment of a bank array included in a semiconductor memory device according to one or more embodiments;
FIGS. 7, 8, 9, and 10 are diagrams illustrating a semiconductor memory device including a vertical channel transistor according to one or more embodiments;
FIG. 11 is a cross-sectional view illustrating an example embodiment of a capacitor array included in a heterogeneous semiconductor die of a semiconductor memory package according to one or more embodiments;
FIG. 12 is a diagram illustrating an example embodiment of an electrode conductor connecting capacitor electrodes of power capacitors included in a capacitor array;
FIGS. 13, 14 and 15 are cross-sectional views illustrating a vertical structure of a semiconductor memory package according to one or more embodiments;
FIG. 16 is a cross-sectional view illustrating a vertical structure of a semiconductor memory package according to one or more embodiments;
FIG. 17 is a schematic diagram illustrating an example embodiment of a heterogeneous semiconductor die included in a semiconductor memory package according to one or more embodiments;
FIG. 18 is a diagram for describing a capacitance of a voltage node of a semiconductor memory package according to one or more embodiments;
FIG. 19 is a diagram illustrating an example embodiment of a heterogeneous semiconductor die included in a semiconductor memory package according to one or more embodiments;
FIG. 20 is a diagram illustrating a stacked memory device according to one or more embodiments;
FIG. 21 is a diagram illustrating a stacked memory device according to one or more embodiments;
FIG. 22 is a diagram illustrating an example structure of a semiconductor package including a semiconductor memory device according to one or more embodiments; and
FIG. 23 is a block diagram illustrating a mobile system including a semiconductor memory device according to one or more embodiments.

### DETAILED DESCRIPTION

One or more embodiments are described more fully hereinafter with reference to the accompanying drawings, in which one or more embodiments are shown. In the drawings, like numerals refer to like elements throughout.

Hereinafter, two directions parallel to the upper surface of the semiconductor substrate and intersecting each other are defined as a first direction D1 and a second direction D2, respectively, and a direction substantially perpendicular to the upper surface of the semiconductor substrate is defined as a third direction D3. For example, the first direction D1 and the second direction D2 may intersect substantially perpendicular to each other. The first direction D1 may be referred to as a row direction or a first horizontal direction, the second direction D2 may be referred to as a column direction or a second horizontal direction, and the third direction D3 may be referred to as a vertical direction. In the drawings, the direction indicated by an arrow and its opposite direction are described as the same direction. The definitions of the aforementioned directions are the same in all subsequent drawings.

Terms such as "unit", "module", "member", and "block" may be embodied as hardware or software. As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element, wherein the indirect connection may include "connection via a wireless communication network".

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expressions "at least one of a, b or c" and "at least one of a, b and c" indicate "only a," "only b," "only c," "both a and b," "both a and c," "both b and c," and "all of a, b, and c."

It will be understood that, although the terms "first", "second", "third", etc., may be used herein to describe various elements, is the disclosure should not be limited by these terms. These terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

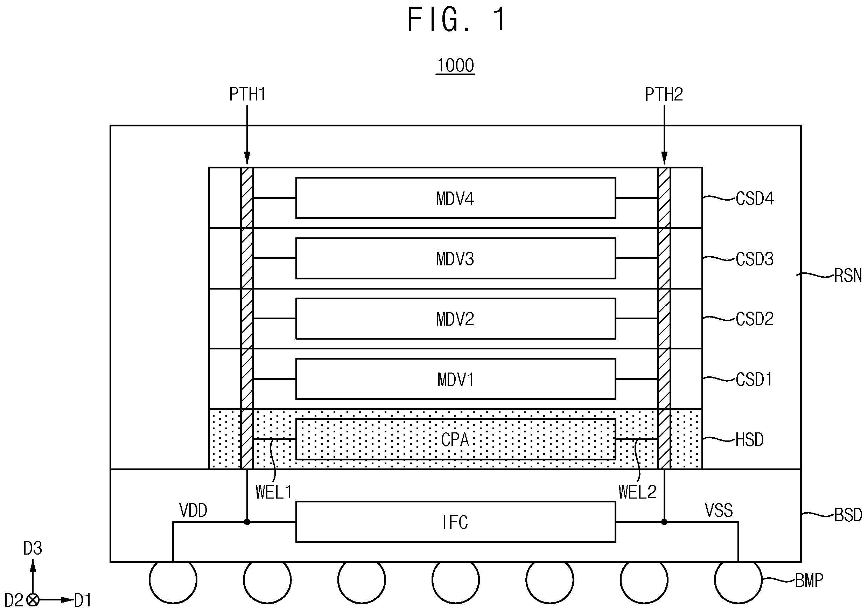

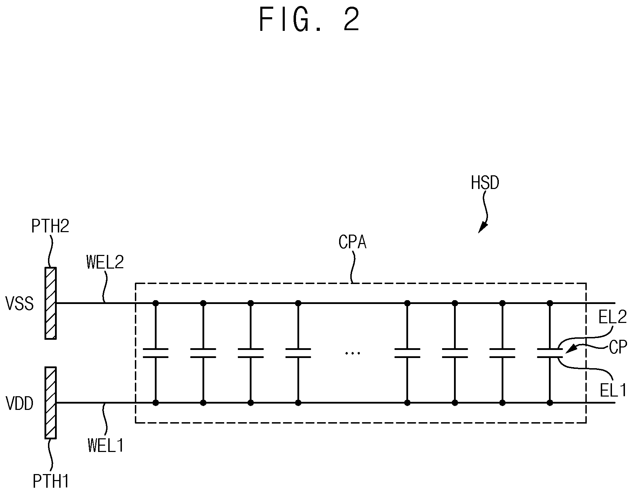

FIG. 1 is a cross-sectional view illustrating a vertical structure of a semiconductor memory package according to one or more embodiments, and FIG. 2 is a schematic diagram illustrating an example embodiment of a heterogeneous semiconductor die included in a semiconductor memory package according to one or more embodiments.

Referring to FIG. 1, a semiconductor memory package 1000 may include a buffer semiconductor die BSD, a plurality of core semiconductor dies CSD1, CSD2, CSD3 and CSD4 (hereinafter referred to as CSD1 through CSD4), and a heterogeneous semiconductor die HSD. While FIG. 1 illustrates an example in which four core semiconductor dies, i.e., first through fourth core semiconductor dies CSD1 through CSD4, are stacked for convenience of illustration and description, the disclosure is not limited thereto. According to one or more embodiments, the number of core semiconductor dies stacked in the semiconductor memory package 1000 may be varied.

External connection members, such as conductive bumps BMP, may be formed on the lower surface of the buffer semiconductor die BSD. The semiconductor dies BSD, HSD and CSD1 through CSD4 may be bonded and electrically connected to each other via bonding pads, microbumps, etc. Inside the core semiconductor dies CSD1 through CSD4, conductive paths such as through-silicon via (TSV) that penetrate the semiconductor die, conductive patterns formed on the conductive layer, vertical contacts, and the like may be formed. The core semiconductor dies CSD1 through CSD4 may be electrically connected to each other via these conductive paths. In one or more embodiments, the through-silicon vias TSV of the uppermost core semiconductor die CSD4 may be omitted. The stacked semiconductor dies BSD, HSD and CSD1 through CSD4 may be packaged using sealing material RSN.

The buffer semiconductor die BSD may include an interface circuit IFC configured to perform communication with an external memory controller. The interface circuit IFC may include circuits for mediating communication between the core semiconductor dies CSD1 through CSD4 and the memory controller, such as circuits corresponding to a physical layer, command-address buffers, data buffers, clock buffers, and the like. The buffer semiconductor die BSD may further include various circuits, such as voltage regulators, power management integrated circuits (PMIC), and the like.

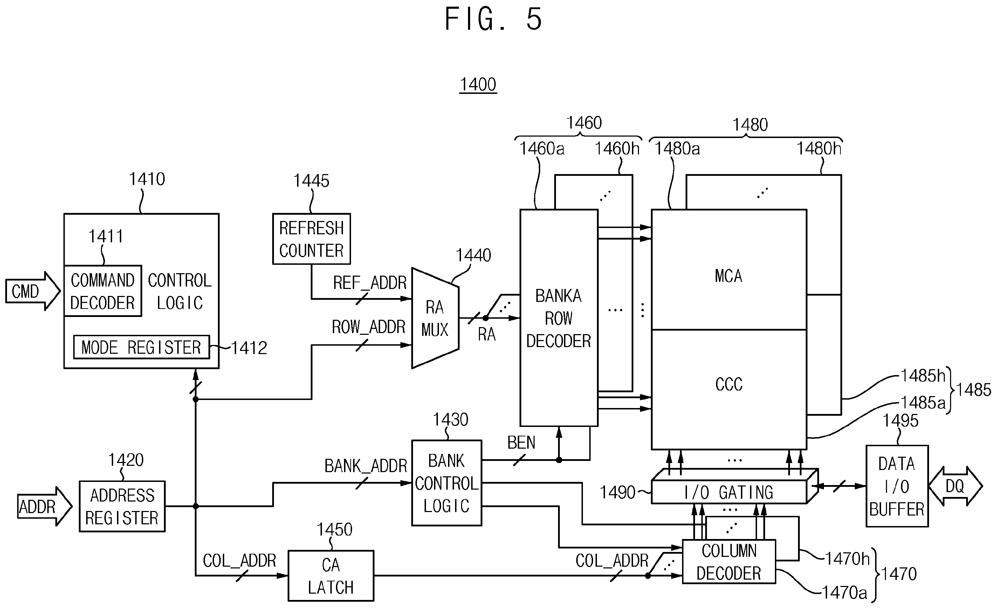

The plurality of core semiconductor dies CSD1 through CSD4 are stacked in the vertical direction D3 on the buffer semiconductor die BSD and include semiconductor memory devices MDV1 through MDV4, respectively. The semiconductor memory devices may include a plurality of memory cells. In one or more embodiments, the plurality of memory cells may be dynamic random access memory (DRAM) cells such that each memory cell one cell capacitor and one cell transistor. One or more embodiments of the semiconductor memory device will be further described below with reference to FIGS. 5 through 10.

The heterogeneous semiconductor die HSD is stacked with the buffer semiconductor die BSD and the plurality of core semiconductor dies CSD1 through CSD4, and the heterogeneous semiconductor die HSD may include a capacitor array CPA. The capacitor array CPA may include a plurality of power capacitors and one or more electrode conductors WEL 1 and WEL2 connecting the electrodes of the plurality of power capacitors.

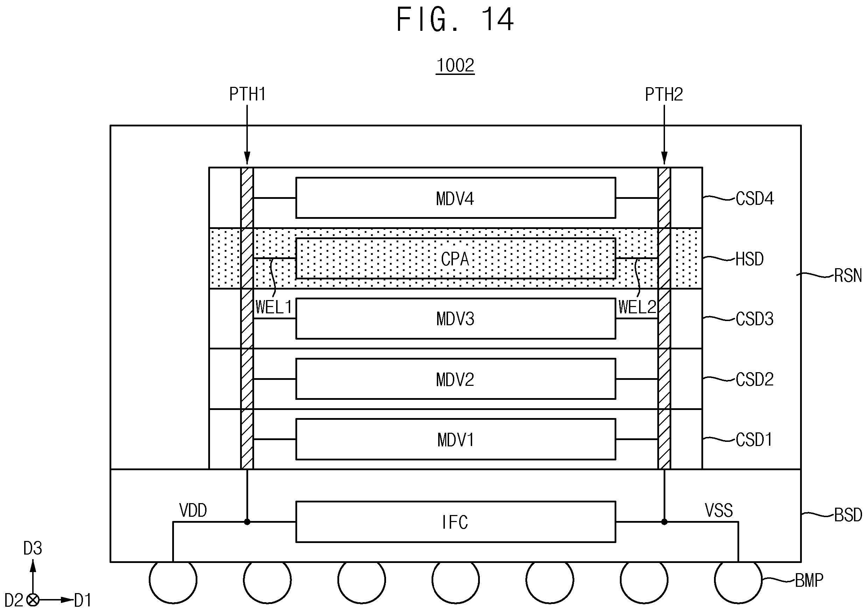

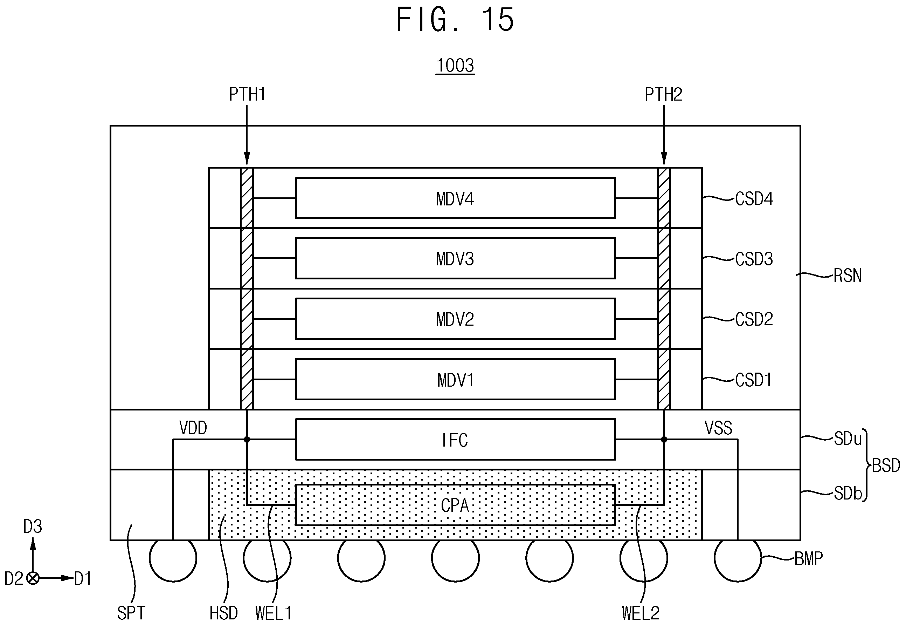

In an example embodiment, as shown in FIG. 1, the heterogeneous semiconductor die HSD may be bonded and stacked the vertical direction D3 to the upper surface of the buffer semiconductor die BSD. In this configuration, by disposing the capacitor array CPA close to the buffer semiconductor die BSD, the voltage level of the power supply voltage VDD provided to the buffer semiconductor die BSD, which has relatively large power consumption, may be efficiently stabilized. As will be described below with reference to FIGS. 14 and 15, the position of the heterogeneous semiconductor die HSD in the stack of semiconductor dies may be varied.

Referring to FIGS. 1 and 2, the capacitor array CPA of the heterogeneous semiconductor die HSD may include a plurality of power capacitors CP. Each power capacitor CP may include a first capacitor electrode EL1 and a second capacitor electrode EL2.

The electrode conductors WEL1 and WEL2 may include a power electrode conductor WEL1 and a ground electrode conductor WEL2.

The power electrode conductor WEL1 may be connected to a power node that provides the power supply voltage VDD to the buffer semiconductor die BSD and the plurality of core semiconductor dies CSD1 through CSD4, and may connect the first capacitor electrodes EL1 of the plurality of power capacitors CP to each other.

The ground electrode conductor WEL2 may be connected to a ground node that provides the ground voltage VSS to the buffer semiconductor die BSD and the plurality of core semiconductor die CSD1 through CSD4, and may connect the second capacitor electrodes EL2 of the plurality of power capacitors CP to each other.

The power supply voltage VDD and the ground voltage VSS may be applied from the memory controller to the semiconductor memory package 1000 via the conductive bumps BMP.

As shown in FIG. 1, the power node providing the power supply voltage VDD may include a power vertical conductive path PTH1 extending in the vertical direction D3, and the ground node providing the ground voltage VSS may include a ground vertical conductive path PTH2 extending in the vertical direction D3. Each of the power vertical conductive path PTH1 and the ground vertical conductive path PTH2 may include through-silicon vias TSV formed inside the semiconductor die HSD and CSD1 through CSD4, and bonding pads included on the upper and lower surfaces of the semiconductor die HSD and CSD1 through CSD4. In one or more embodiments, the through-silicon vias TSV of the uppermost core semiconductor die CSD4 may be omitted.

As shown in FIGS. 1 and 2, the power supply voltage VDD is provided to the plurality of core semiconductor dies CSD1 through CSD4 via the power vertical conductive path PTH1 extending in the vertical direction D3, and the power electrode conductor WEL1 is connected to the power vertical conductive path PTH1 and the first capacitor electrodes EL1 of the plurality of power capacitors CP included in the capacitor array CPA.

Similarly, as shown in FIGS. 1 and 2, the ground voltage VSS is provided to the plurality of core semiconductor dies CSD1 through CSD4 via the ground vertical conductive path PTH2 extending in the vertical direction D3, and the ground electrode conductor WEL2 is connected to the ground vertical conductive path PTH2 and the second capacitor electrodes EL2 of the plurality of power capacitors CP included in the capacitor array CPA.

In one or more embodiments, the ground electrode conductor WEL2 and the ground vertical conductive path PTH2 may be omitted, and the second capacitor electrodes EL2 of the plurality of power capacitors CP may be floated.

With the rise of technologies such as autonomous driving and artificial intelligence, research and development of high-performance and high-bandwidth memories (HBMs) have been actively pursued due to the need to quickly and accurately process the large amounts of data required by autonomous driving and artificial intelligence.

The high-bandwidth memory refers to a memory that is vertically stacked with dynamic random access memory (DRAM) using through-silicon vias (TSV). By utilizing through-silicon via technology, the high-bandwidth memory may have the advantage of lower power consumption due to shorter signal lines than conventional horizontally-transmitted memory.

Specifically, the high-bandwidth memory has the advantage of securing high-bandwidth by dramatically increasing the number of inputs and outputs by stacking multiple DRAM dies in the vertical direction D3.

High-bandwidth memory continues to increase in the number of stacked DRAM dies with each generation, but the power supply voltage is decreasing, for example from 1.2V to 0.8V. Currently, DDR5 memory, a type of DRAM, has a power supply voltage of 1.1V. As the power supply power decreases, so does the noise margin that determines whether a signal's logic state is HIGH or LOW. As a result, power integrity in the high-bandwidth memory is becoming increasingly important with each passing generation.

To ensure performance in high-speed and high-bandwidth systems, integrated circuits (ICs) require a reliable power source, and the power grid for this is called the Power Distribution Network (PDN). Since all the semiconductor chips in a system are connected to the PDN, noise may cause problems for the entire system.

Simultaneous switching noise (SSN) is a typical noise in PDN, which refers to the fact that when a large number of circuits are switching at the same time, a high current flows instantaneously, and the switching current is multiplied by the impedance of the PDN to generate unwanted voltage jumps.

This SSN voltage may degrade the performance of the system and, in the worst case, change the logic state, so it is important to analyze and design the impedance of the PDN to predict and reduce noise.

The impedance of the PDN depends on observation positions, but the impedance may be lowered by increasing the capacitance of the voltage transmission path and decreasing the inductance. A popular way to lower impedance is to add decoupling capacitors to the PDN to reduce impedance.

However, the process of placing capacitors in high-bandwidth memory is complicated and expensive, so off-chip capacitors, such as multi-layer ceramic capacitors, are being utilized on the outside of the buffer semiconductor die BSD or semiconductor memory package 1000. These off-chip capacitors occupy a large footprint and reduce the design margin of the integrated circuit.

The semiconductor memory package 1000 according to one or more embodiments may increase the capacitance of the voltage node and efficiently improve the voltage characteristics of the semiconductor memory package 1000 without increasing the occupied area of the semiconductor memory package 1000 by stacking the heterogeneous semiconductor die HSD including the plurality of power capacitors CP together with the core semiconductor dies CSD1 through CSD4 and by connecting the plurality of power capacitors CP to the voltage node.

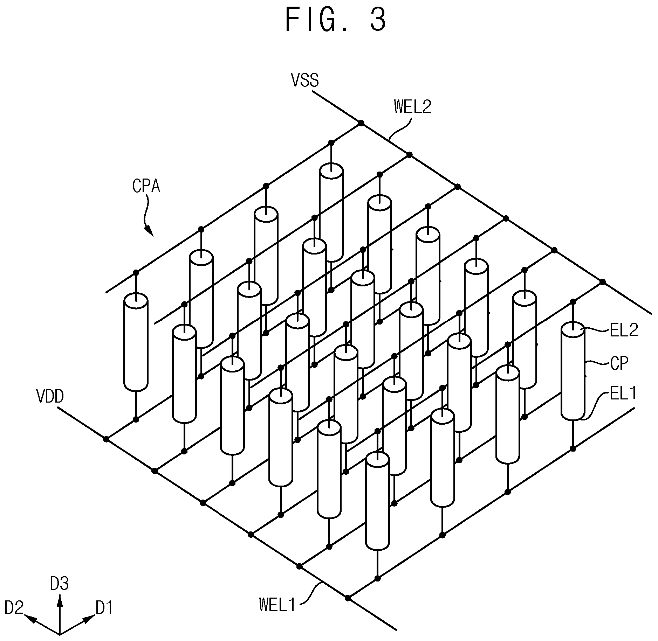

FIG. 3 is a perspective view illustrating an example embodiment of a capacitor array included in the heterogeneous semiconductor die of FIG. 2.

Referring to FIG. 3, a capacitor array CPA may include cylinder-shaped or pillar-shaped capacitors arranged repeatedly in the first horizontal direction D1 and the second horizontal direction D2. The cylinder-shaped or pillar-shaped capacitors may provide a large opposing area of electrodes in the vertical direction D3. Thus, the capacitor array CPA including cylinder-shaped or pillar-shaped capacitors may provide a large capacitance with a relatively small footprint. As used herein, the term "pillar-shaped" means an elongated, three-dimensional shape including any one of a variety of cross-sectional shapes, such cross-sectional shapes including, without limitation, polygonal, oval, or irregular.

As shown in FIG. 3, the power electrode conductor WEL1 connected to a voltage node to which the power supply voltage VDD is applied may connect the first electrodes EL1 of the power capacitors CP to each other, and the ground electrode conductor WEL2 connected to a ground node to which the ground voltage VSS is applied may connect the second electrodes EL2 of the power capacitors CP to each other. Thus, the power capacitors CP may be connected in parallel between the power electrode conductors WEL1 and the ground electrode conductors WEL2, and may provide a capacitance proportional to the number of the power capacitors CP.

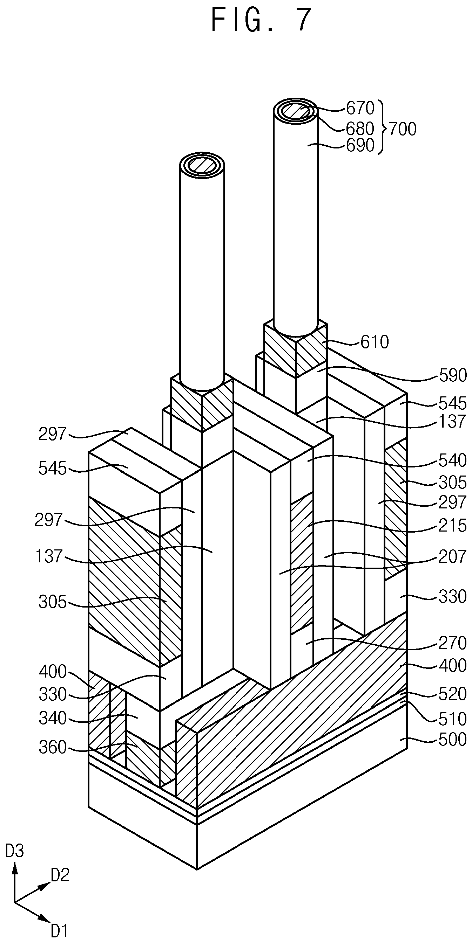

As will be described below with reference to FIGS. 7 through 10, the power capacitors CP of the capacitor array CPA may have the same shape as the cell capacitors included in the memory cells of the semiconductor memory device of the core semiconductor dies CSD1 through CSD4, and may be repeatedly disposed on the upper surface of the semiconductor substrate.

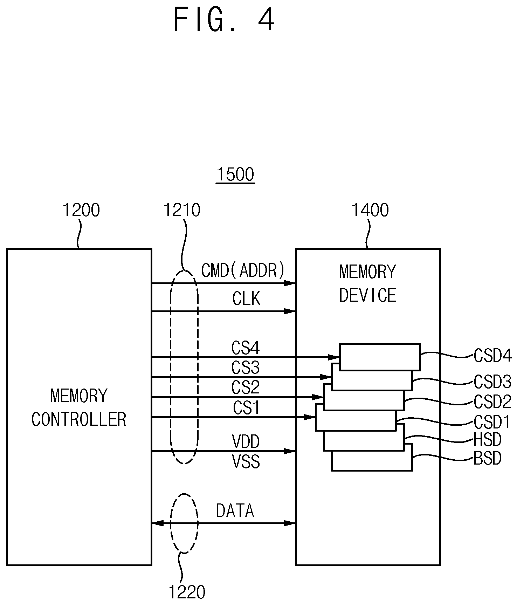

FIG. 4 is a block diagram illustrating a memory system according to one or more embodiments.

Referring to FIG. 4, a memory system 1500 includes a memory controller 1200 and a memory device 1400. Each of the memory controller 1200 and the memory device 1400 includes an interface for communicating with each other.

The interfaces may be connected via a control bus 1210 for transmitting commands CMD, access addresses ADDR, clock signals CLK, control signals, voltages VDD and VSS, and the like, and a data bus 1220 for transmitting data.

Depending on the type of the memory device 1400, the command CMD may be considered to include the access address ADDR. The memory controller 1200 generates commands CMD to control the memory device 1400, and under the control of the memory controller 1200, data may be written to the memory device 1400 or data may be read from the memory device 1400.

The memory device 1400 may be implemented in the form of a semiconductor memory package in which semiconductor dies BSD, HSD and CSD1 through CSD4 are stacked, as described with reference to FIGS. 1 through 3. The plurality of core semiconductor dies CSD1 through CSD4 may be selectively activated based on each of the plurality of chip selection signals CS1, CS2, CS3 and CS4. When the plurality of core semiconductor dies CSD1 through CSD4 belong to one and the same channel, only one of the plurality of chip selection signals CS1, CS2, CS3 and CS4 may be activated and the others may be deactivated.

FIG. 5 is a block diagram illustrating a semiconductor memory device according to example embodiment.

Referring to FIG. 5, a memory device 1400 includes a control logic 1410, an address register 1420, a bank control logic 1430, a row address multiplexer 1440, a column address latch 1450, a row decoder 1460, a column decoder 1470, a memory cell array MCA 1480, a core control circuit CCC 1485, an input-output (I/O) gating circuit 1490, a data input-output (I/O) buffer 1495, and a refresh counter 1445.

The memory cell array 1480 may include a plurality of bank arrays 1480a-1480h. The row decoder 1460 may include a plurality of bank row decoders 1460a-1460h respectively coupled to the bank arrays 1480a-1480h. The column decoder 1470 may include a plurality of bank column decoders 1470a-1470h respectively coupled to the bank arrays 1480a-1480h, and the core control circuit 1485 may include a plurality of bank core control circuits 1485a-1485h respectively coupled to the bank arrays 1480a-1480h. The plurality of bank arrays 1480a-1480h and the plurality of bank core control circuits 1485a-1485h may be stacked in a vertical direction to form a CoP (cell over periphery) structure.

The address register 1420 may receive an address ADDR including a bank address BANK_ADDR, a row address ROW_ADDR and a column address COL_ADDR from a memory controller. The address register 1420 may provide the received bank address BANK_ADDR to the bank control logic 1430 and may provide the received row address ROW_ADDR to the row address multiplexer 1440. In addition, the address register 1420 may provide the received column address COL_ADDR to the column address latch 1450.

The bank control logic 1430 may generate bank control signals in response to the bank address BANK_ADDR. The bank control signals may include bank enable signals BEN to activate a selection memory bank corresponding to the bank address BANK_ADDR. One of the bank row decoders 1460a-460h corresponding to the bank address BANK_ADDR may be activated in response to the bank control signals, and one of the bank column decoders 1470a-1470h corresponding to the bank address BANK_ADDR may be activated in response to the bank control signals.

The row address multiplexer 1440 may receive the row address ROW_ADDR from the address register 1420 and may receive a refresh row address REF_ADDR from the refresh counter 1445. The row address multiplexer 1440 may selectively output the row address ROW_ADDR or the refresh row address REF_ADDR as a row address RA. The row address RA that is output from the row address multiplexer 1440 may be applied to the bank row decoders 1460a-1460h.

The activated one of the bank row decoders 1460a-1460h may decode the row address RA that is output from the row address multiplexer 1440 and may activate a word-line corresponding to the row address RA. For example, the activated bank row decoder may apply a word-line driving voltage to the word-line corresponding to the row address RA.

The column address latch 1450 may receive the column address COL_ADDR from the address register 1420 and may temporarily store the received column address COL_ADDR. In one or more embodiments, in a burst mode, the column address latch 1450 may generate column addresses that increment from the received column address COL_ADDR. The column address latch 1450 may apply the temporarily stored or generated column address to the bank column decoders 1470a-1470h.

The activated one of the bank column decoders 1470a-1470h may decode the column address COL_ADDR that is output from the column address latch 1450 and may control the input-output I/O gating circuit 1490 to output data corresponding to the column address COL_ADDR.

The I/O gating circuit 1490 may include a circuitry for gating input-output data. The I/O gating circuit 1490 may further include read data latches and write drivers. The read data latches are for storing data that is output from the bank arrays 1480a-1480h, and the write drivers are for writing data to the bank arrays 1480a-1480h.

Data to be read from one bank array of the bank arrays 1480a-1480h may be sensed by the CCC 1485 coupled to the one bank array from which the data is to be read and may be stored in the read data latches. The data stored in the read data latches may be provided to the memory controller via the data I/O buffer 1495. Data DQ to be written in one bank array of the bank arrays 1480a-1480h may be provided to the data I/O buffer 1495 from the memory controller. The write driver may write the data DQ in one bank array of the bank arrays 1480a-1480h.

The control logic 1410 may control operations of the memory device 1400. For example, the control logic 1410 may generate control signals for the memory device 1400 to perform a write operation or a read operation. The control logic 1410 may include a command decoder 1411 and a mode register set 1412. The command decoder decodes a command CMD received from the memory controller, and the mode register set 1412 sets an operation mode of the memory device 1400.

For example, the command decoder 1411 may generate the control signals corresponding to the command CMD by decoding a write enable signal, a row address strobe signal, a column address strobe signal, a chip selection signal, etc.

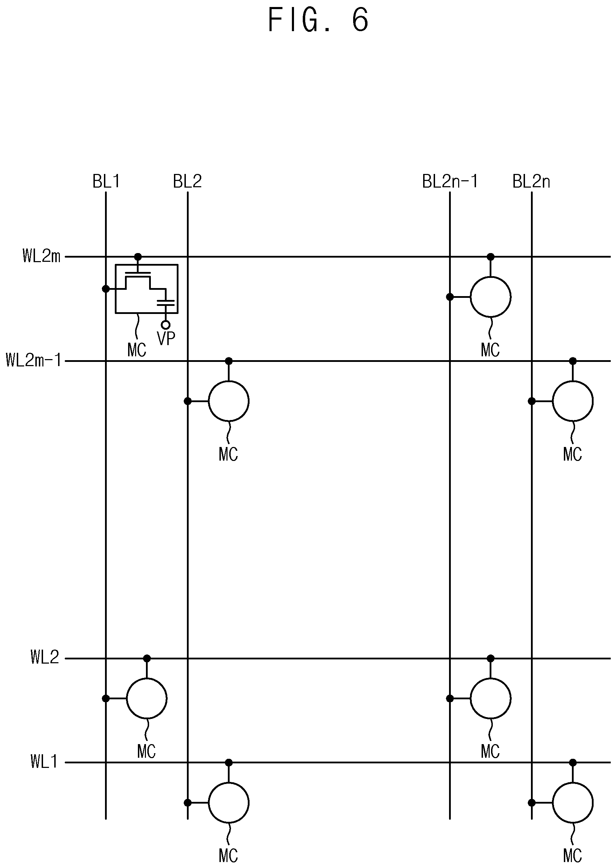

FIG. 6 is a diagram illustrating an example embodiment of a bank array included in a semiconductor memory device according to one or more embodiments.

Referring to FIG. 6, a bank array includes a plurality of wordlines WL1 through WL2m, where m is a binary integer, a plurality of bitlines BL1 through BL2n, where n is a binary integer, and a plurality of memory cells MC disposed at intersections between the wordlines WL1 through WL2m and the bitlines BL1 through BL2n. As shown in FIG. 6, each memory cell MC may have a DRAM cell structure. The memory cells MC may include a cell capacitor connected to a plate voltage VP and a cell transistor connected between each bitline and the cell capacitor and the gate electrode of the cell transistor is connected to each wordline. The wordlines to which the memory cells MC are connected may be defined as rows of the bank array, and the bitlines to which the memory cells MC are connected may be defined as columns of the bank array.

The semiconductor memory device according to one or more embodiments of the present disclosure may be a DRAM device as described with reference to FIGS. 5 and 6, but the disclosure is not limited to any particular type of memory.

FIGS. 7, 8, 9, and 10 are diagrams illustrating a semiconductor memory device including a vertical channel transistor according to one or more embodiments.

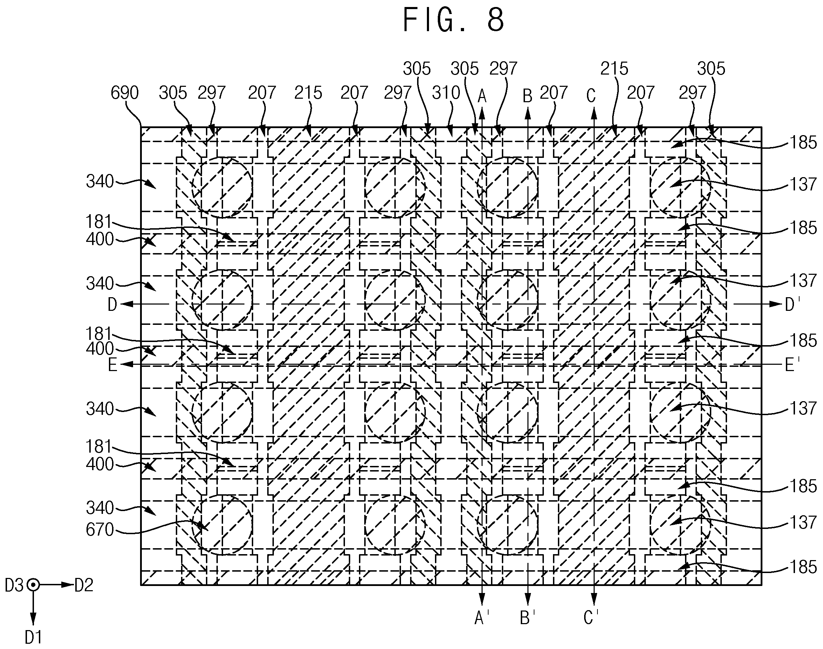

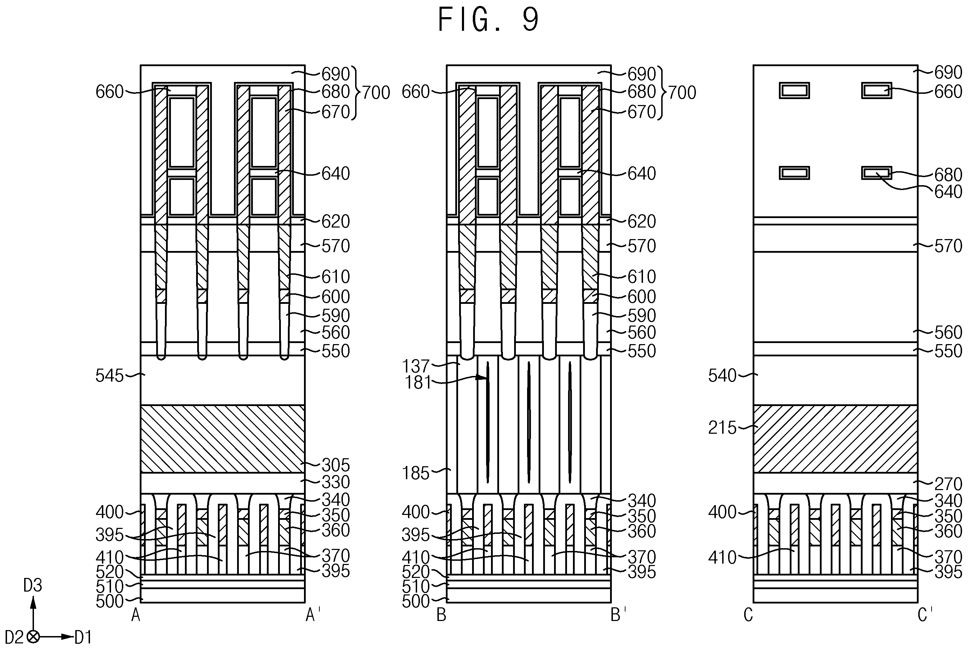

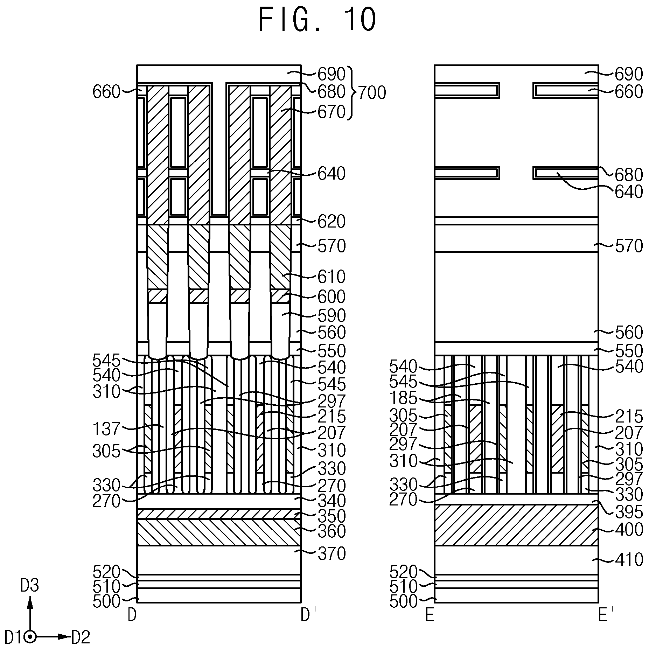

For example, FIG. 7 is a perspective view, FIG. 8 is a plan view, and FIGS. 9 and 10 are cross-sectional views. FIG. 9 includes cross-sectional views taken along lines A-A', B-B' and C-C', respectively, of FIG. 8. FIG. 10 includes cross-sectional views taken along lines D-D' and E-E', respectively, of FIG. 8. For simplicity, FIG. 7 does not show some elements.

Referring to FIGS. 7 through 10, the semiconductor device includes a bitline structure, a first shield pattern 400, a semiconductor pattern 137, first and second gate electrodes 215 and 305, first and second gate insulation patterns 207 and 297, a contact plug structure and a capacitor 700 disposed on a second substrate 500.

The semiconductor device may further include first and second adhesion layers 520 and 510, a third spacer 395, a first insulating interlayer pattern 185, second and third insulating interlayers 310 and 560, a third insulation layer 270, fourth to seventh insulation patterns 330, 410, 540 and 545, first and second etch stop layers 550 and 620, a capping layer 570, and first and second support layers 640 and 660.

The second substrate 500 may include, e.g., a semiconductor material, an insulation material or a conductive material.

The second adhesion layer 510 and the first adhesion layer 520 may be stacked in the third direction D3, and may include an insulating material, e.g., silicon carbonitride.

The bitline structure may include a mask pattern 370, a second conductive pattern 360, a barrier pattern 350 and a first conductive pattern 340 sequentially stacked in the third direction D3.

In an example embodiment, the first conductive pattern 340 may include polysilicon doped with n-type or p-type impurities, the barrier pattern 350 may include a metal nitride, e.g., titanium nitride, tantalum nitride, tungsten nitride, etc., and the second conductive pattern 360 may include a metal, e.g., tungsten, titanium, tantalum, etc.

In one or more embodiments, a plurality of bitline structures may be spaced apart from each other in the first direction D1, and each of the plurality of bitline structures may extend in the second direction D2 on and contacting an upper surface of the first adhesion layer 520.

The first shield pattern 400 may extend in the second direction D2 between neighboring ones of the bitline structures in the first direction D1. In one or more embodiments, an upper surface and a sidewall of the first shield pattern 400 may be covered by the third spacer 395 extending in the second direction D2, and a lower surface of the first shield pattern 400 may be covered by a fifth insulation pattern 410 extending in the second direction D2. As the first shield pattern 400 is formed, the disturbance and parasitic capacitance between the bitline structures may decrease, and thus, the RC-delay may be reduced, which may increase the operation speed of the semiconductor device.

A sidewall of the fifth insulation pattern 410 may be covered by the third spacer 395. Lower surfaces of the third spacer 395 and the fifth insulation pattern 410 may contact an upper surface of the first adhesion layer 520.

In one or more embodiments, the third spacer 395 may contact a sidewall of the bitline structure. Upper and lower surfaces of the third spacer 395 may be substantially coplanar with upper and lower surfaces, respectively, of the bitline structure.

The first shield pattern 400 may include a metal nitride, e.g., titanium nitride, tantalum nitride, etc., and the third spacer 395 and the fifth insulation pattern 410 may include an oxide, e.g., silicon oxide.

In one or more embodiments, a plurality of semiconductor patterns 137 may be spaced apart from each other in the second direction D2 on each of the bitline structures, and each of the plurality of semiconductor patterns 137 may contact the first conductive pattern 340 included in each of the bitline structures. As the bitline structures are spaced apart from each other in the first direction D1, a plurality of semiconductor patterns 137 may be spaced apart from each other in the first and second directions D1 and D2.

In one or more embodiments, the semiconductor pattern 137 may include a single crystalline semiconductor material, e.g., single crystalline silicon, single crystalline germanium, etc., or a polycrystalline semiconductor material, e.g., polysilicon, polygermanium, etc., and may serve as a channel of the semiconductor device. However, n-type or p-type impurities may be doped into upper and lower portions of the semiconductor pattern 137, and may serve as source/drain regions of the semiconductor device, unlike a central portion of the semiconductor pattern 137 serving as the channel. Thus, current may flow in the vertical direction, that is, in the third direction D3 in the semiconductor pattern 137, and thus the semiconductor device may include a vertical channel transistor (VCT) having a vertical channel.

Alternatively, the semiconductor pattern 137 may include a single crystalline semiconductor material or a polycrystalline semiconductor material doped with n-type or p-type impurities. In this case, a concentration of the impurities in a central portion of the semiconductor pattern 137 serving as a channel may be lower than concentrations of the impurities in upper and lower portions of the semiconductor pattern 137 serving as source/drain regions, respectively.

In an example embodiment, p-type impurities may be doped into the central portion of the semiconductor pattern 137 with a relatively low concentration, and n-type impurities may be doped into the upper and lower portions of the semiconductor pattern 137 with relatively high concentrations, respectively.

The first insulating interlayer pattern 185 may be formed between neighboring ones of the semiconductor patterns 137 in the first direction D1. Thus, the semiconductor pattern 137 and the first insulating interlayer pattern 185 may be alternately and repeatedly disposed in the first direction D1.

A lower surface of the first insulating interlayer pattern 185 may contact an upper surface of the third spacer 395. In one or more embodiments, a width in the second direction D2 of the first insulating interlayer pattern 185 may be greater than a width in the second direction D2 of the semiconductor pattern 137. The first insulating interlayer pattern 185 may include an oxide, e.g., silicon oxide.

In one or more embodiments, a seam 181 or a void may be formed in a central portion in the first direction D1 of the first insulating interlayer pattern 185.

The second gate electrode 305 may extend in the first direction D1 at sides in the second direction D2 of the semiconductor patterns 137 and the first insulating interlayer patterns 185, and the first gate electrode 215 may extend in the first direction D1 at other sides in the second direction D2 of the semiconductor patterns 137 and the first insulating interlayer patterns 185.

For example, each of the semiconductor patterns 137 may include first and second sidewalls disposed opposite to each other in the second direction D2, each of the first insulating interlayer patterns 185 may include third and fourth sidewalls disposed opposite to each other in the second direction D2, the second gate electrode 305 may be disposed adjacent to the first sidewalls of the semiconductor patterns 137 and the third sidewalls of the first insulating interlayer patterns 185, and the first gate electrode 215 may be disposed adjacent to the second sidewalls of the semiconductor patterns 137 and the fourth sidewalls of the first insulating interlayer patterns 185.

The first and second gate electrodes 215 and 305 may include a metal, e.g., molybdenum, ruthenium, tungsten, etc., a metal nitride, e.g., titanium nitride, tantalum nitride, tungsten nitride, etc., or a metal silicide.

In one or more embodiments, the second gate electrode 305 may be a front gate electrode with respect to each of the semiconductor patterns 137 and may serve as a wordline in the semiconductor device. The first gate electrode 215 may be a back gate electrode with respect to each of the semiconductor patterns 137.

In one or more embodiments, the semiconductor patterns 137 may include first semiconductor patterns disposed in the first direction D1, and second semiconductor patterns disposed in the first direction D1 and spaced apart from the first semiconductor patterns in the second direction D2.

In one or more embodiments, the wordlines may include a first wordline extending in the first direction D1 adjacent to the first sidewalls of the first semiconductor patterns and a second wordline extending in the first direction D1 adjacent to the first sidewalls of the second semiconductor patterns, and the second sidewalls of the first and second semiconductor patterns may face each other in the second direction D2. The back gate electrode 215 may be formed between the second sidewalls of the first semiconductor patterns and the second sidewalls of the second semiconductor patterns.

For example, the first wordline, the first sidewall and the second sidewall of each of the first semiconductor patterns, the back gate electrode 215, the second and first sidewalls of each of the second semiconductor patterns, and the second wordline may be disposed in the second direction D2 in this order.

In one or more embodiments, the first and second wordlines at opposite sides, respectively, in the second direction D2 of the back gate electrode 215 may form a wordline pair, and a plurality of wordline pairs may be disposed in the second direction D2. The second insulating interlayer 310 may be formed between neighboring ones of the wordline pairs in the second direction D2, and may include an oxide, e.g., silicon oxide.

In one or more embodiments, a width in the second direction D2 of a portion of the first gate electrode 215 adjacent to each of the first insulating interlayer patterns 185 may be greater than a width in the second direction D2 of a portion of the first gate electrode 215 adjacent to each of the semiconductor patterns 137. Thus, a width of the first gate electrode 215 in the second direction D2 may periodically vary in the first direction D1.

In one or more embodiments, a width of the second gate electrode 305 in the second direction D2 may be constant in the first direction D1. The second gate electrode 305 may extend in the first direction D1, and a concave portion and a convex portion in the second direction D2 may be alternately and repeatedly disposed in the first direction D1.

In one or more embodiments, upper and lower surfaces of the first gate electrode 215 may be substantially coplanar with upper and lower surfaces, respectively, of the second gate electrode 305. However, the present disclosure is not limited thereto.

In one or more embodiments, a lower surface of the first gate electrode 215 may be covered by the third insulation layer 270, and an upper surface of the first gate electrode 215 may be covered by the sixth insulation pattern 540. Additionally, a lower surface of the second gate electrode 305 may be covered by the fourth insulation pattern 330, and an upper surface of the second gate electrode 305 may be covered by the seventh insulation pattern 545.

In one or more embodiments, lower surfaces of the third insulation layer 270 and the fourth insulation pattern 330 may be substantially coplanar with each other and may contact upper surfaces of the bitline structure and the third spacer 395. Additionally, upper surfaces of the sixth insulation pattern 540 and the seventh insulation pattern 545 may be substantially coplanar with each other.

The third insulation layer 270, and the fourth, sixth and seventh insulation patterns 330, 540 and 545 may include an oxide, e.g., silicon oxide.

The second gate insulation pattern 297 may extend in the first direction **D1 on** and contacting the first sidewalls of the semiconductor patterns 137 and the third sidewalls of the first insulating interlayer patterns 185, and the first gate insulation pattern 207 may extend in the first direction D1 on and contacting the second sidewalls of the semiconductor patterns 137 and the fourth sidewalls of the first insulating interlayer patterns 185. Thus, the second gate insulation pattern 297 may be formed of each of the semiconductor patterns 137 and the second gate electrode 305, and the first gate insulation pattern 207 may be formed of each of the semiconductor patterns 137 and the first gate electrode 215.

The first gate insulation pattern 207 may cover not only the sidewall of the first gate electrode 215, but also sidewalls of the sixth insulation pattern 540 and the third insulation layer 270 on and beneath, respectively, the first gate electrode 215. The second gate insulation pattern 297 may cover not only the sidewall of the second gate electrode 305, but also sidewalls of the seventh insulation pattern 545 and the fourth insulation pattern 330 on and beneath, respectively, the second gate electrode 305.

Each of the first and second gate insulation patterns 207 and 297 may include an oxide, e.g., silicon oxide. Alternatively, each of the first and second gate insulation patterns 207 and 297 may have a multi-layered structure including a first layer containing silicon oxide and contacting the semiconductor pattern 137 and a second layer containing a metal oxide, e.g., hafnium oxide, zirconium oxide, etc., and contacting a sidewall of the first layer and a sidewall of the first insulating interlayer pattern 185.

In one or more embodiments, a width in the second direction D2 of a portion of each of the first and second gate insulation patterns 207 and 297 adjacent to the sidewall of each of the semiconductor patterns 137 may be greater than a width in the second direction D2 of a portion of each of the first and second gate insulation patterns 207 and 297 adjacent to the sidewall of each of the first insulating interlayer patterns 185. Thus, a width in the second direction D2 of each of the first and second gate insulation patterns 207 and 297 may be periodically changed in the first direction D1.

As illustrated above, if each of the first and second gate insulation patterns 207 and 297 has the multi-layered structure including the first and second layers, the portion of each of the first and second gate insulation patterns 207 and 297 contacting each of the semiconductor patterns 137 may include both of the first and second layers, while the portion of each of the first and second gate insulation patterns 207 and 297 contacting each of the first insulating interlayer patterns 185 may include only the second layer.

The first etch stop layer 550, the third insulating interlayer 560 and the capping layer 570 may be sequentially stacked on the semiconductor pattern 137, the first insulating interlayer pattern 185, the second insulating interlayer 310, the first and second gate insulation patterns 207 and 297, and the sixth and seventh insulation patterns 540 and 545, and the contact plug structure may extend through the first etch stop layer 550, the third insulating interlayer 560 and the capping layer 570 to contact an upper surface of the semiconductor pattern 137.

The first etch stop layer 550 and the capping layer 570 may include an insulating nitride, e.g., silicon nitride, and the third insulating interlayer 560 may include an oxide, e.g., silicon oxide.

As a plurality of semiconductor patterns 137 are spaced apart from each other in the first and second directions D1 and D2, a plurality of contact plug structures may also be spaced apart from each other in the first and second directions D1 and D2. In an example embodiment, the contact plug structures may be arranged in a lattice pattern in a plan view. Alternatively, the contact plug structures may be arranged in a honeycomb pattern in a plan view.

The contact plug structure may contact not only the upper surface of each of the semiconductor patterns 137, but also upper surfaces of the first and second gate insulation patterns 207 and 297 and the sixth and seventh insulation patterns 540 and 545 adjacent to each of the semiconductor patterns 137.

The contact plug structure may include a lower contact plug 590, an ohmic contact pattern 600 and an upper contact plug 610 sequentially stacked in the third direction D3.

The lower contact plug 590 may include polysilicon doped with n-type or p-type impurities, the ohmic contact pattern 600 may include a metal silicide, e.g., cobalt silicide, nickel silicide, titanium silicide, etc., and the upper contact plug 610 may include a conductive material, e.g., a metal, a metal nitride, a metal silicide, etc.

The second etch stop layer 620 may be formed on the third insulating interlayer 560 and the contact plug structure, and a first capacitor electrode 670 may extend through the second etch stop layer 620 in the third direction D3.

As the plurality of contact plug structures are spaced apart from each other in the first and second directions D1 and D2, a plurality of first capacitor electrodes 670 may also be spaced apart from each other in the first and second directions D1 and D2.

In one or more embodiments, the first capacitor electrode 670 may have a shape of, for example, a circle, an ellipse, a polygon, a polygon with rounded corners, etc., in a plan view. In an example embodiment, the first capacitor electrodes 670 may be arranged in a lattice pattern in a plan view. Alternatively, the first capacitor electrodes 670 may be arranged in a honeycomb pattern in a plan view.

The first and second support layers 640 and 660 may contact central and upper portions, respectively, of each of the first capacitor electrodes 670 which may prevent the first capacitor electrodes 670 from falling down.

A dielectric layer 680 may be formed on surfaces of the first capacitor electrodes 670 and the first and second support layers 640 and 660, and a second capacitor electrode 690 may be formed on the dielectric layer 680. The first and second capacitor electrodes 670 and 690 and the dielectric layer 680 may collectively form the capacitor 700.

The second etch stop layer 620 may include an insulating nitride, e.g., silicon boronitride, silicon carbonitride, etc., and the first and second support layers 640 and 660 may include an insulating nitride, e.g., silicon nitride. The first capacitor electrode 670 may include a metal nitride, e.g., titanium nitride, tantalum nitride, etc., or a metal, e.g., titanium, tantalum, tungsten. The dielectric layer 680 may include a metal oxide having a high dielectric constant, e.g., hafnium oxide, zirconium oxide, etc., and the second capacitor electrode 690 may include, e.g., silicon-germanium doped with impurities.

In one or more embodiments, another type of data storage structure instead of the capacitor 700 may be formed on each of the contact plug structures, and the data storage structure may include a variable resistance pattern containing, e.g., a phase-change material, a transition metal oxide, a magnetic material, etc.

FIGS. 7 through 10 show only a cell region of the semiconductor device. However, some elements shown in FIGS. 7 through 10 may also be formed on a peripheral circuit region of the semiconductor device.

For example, FIG. 8 shows the second gate electrode 305 serving as a wordline extending in the first direction D1. However, according to one or more embodiments, each of the first and second wordlines forming a wordline pair may include an extension portion extending in the second direction D2 on the peripheral circuit region, and the first and second wordlines may have a ring shape on the cell region and the peripheral circuit region in a plan view. In one or more embodiments, a division layer may be formed between the first and second wordlines on the peripheral circuit region or on the cell region so that the first and second wordlines may be electrically insulated from each other.

Additionally, the first shield pattern 400 extending in the second direction D2 between neighboring bitline structures may include an extension portion extending in the first direction D1 on the peripheral circuit region, and the first shield patterns 400 spaced apart from each other in the first direction D1 on the cell region may be connected with each other on the peripheral circuit region. Contact plugs and wirings may be further formed on the peripheral circuit region to be connected to the bitline structure and the first shield pattern 400.

In one or more embodiments, the semiconductor device may include a vertical channel transistor (VCT), which may include the semiconductor pattern 137 serving as a channel, the second gate electrode 305 serving as a front gate electrode, and the first gate electrode 215 serving as a back gate electrode. The back gate electrode 215 may increase a threshold voltage of the VCT. As a result, leakage current characteristics may not be deteriorated even if the VCT has a minute size.

Additionally, the back gate electrode 215 may be disposed between two second gate electrodes 305 to commonly apply a voltage to channels in the semiconductor patterns 137 at opposite sides, respectively. As a result, the integration degree of the semiconductor device may increase when compared to a VCT having a double gate structure in which two gate electrodes are disposed at opposite sides, respectively, of a channel.

According to one or more embodiments, the semiconductor pattern 137 of the VCT includes a single crystalline semiconductor material. As a result, the leakage current characteristics may be further enhanced.

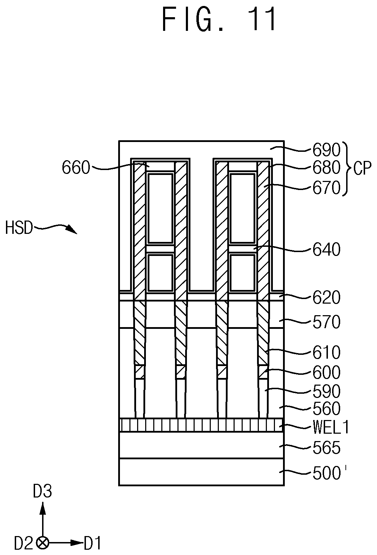

FIG. 11 is a cross-sectional view illustrating an example embodiment of a capacitor array included in a heterogeneous semiconductor die of a semiconductor memory package according to one or more embodiments.

The heterogeneous semiconductor die HSD of FIG. 11 is identical or similar to some of the components described with reference to FIGS. 7 through 10, and thus repeated descriptions are omitted herein. Referring to FIG. 11, the heterogeneous semiconductor die HSD may include a plurality of power capacitors CP disposed on a top portion of a semiconductor substrate 500'. First and second capacitor electrodes 670 and 690 and dielectric film 680 may together form the power capacitors CP. The power capacitors CP may be repeatedly disposed in the first horizontal direction D1 and the second horizontal direction D2.

The first capacitor electrodes 670 of the power capacitors CP may be electrically connected to a power electrode conductor WEL1 via contact plug structures. As described with reference to FIGS. 7 through 10, the contact plug structures may include a lower contact plug 590, an ohmic contact pattern 600, and an upper contact plug 610 stacked sequentially in the vertical direction D3.

The second capacitor electrodes 690 of the power capacitors CP may be integrally formed from a single conductor. The single conductor formed by the second capacitor electrodes 690 may correspond to a ground electrode conductor WEL2 as described above.

As such, the cell capacitors 700 described with reference to FIGS. 7 through 10 and the power capacitors CP described with reference to FIG. 11 may have the same shape.

Although one or more embodiments of the cell capacitors 700 and power capacitors CP described with reference to FIGS. 7 through 11 are cylindrical in shape, the cell capacitors 700 and power capacitors CP may have various shapes. In one or more embodiments, the cell capacitor 700 and the power capacitor CP may be formed in a pillar shape. The pillar-shaped capacitor may include a center corresponding to a first capacitor electrode, a dielectric film surrounding the center, and a second capacitor electrode surrounding the dielectric film.

As shown in FIG. 11, an interlayer insulating film 565 may be interposed between the semiconductor substrate 500' and the power electrode conductor WEL1. Active devices such as transistors may be formed on the semiconductor substrate 500' and the interlayer insulating film 565. In addition, conductive layers such as metal layers and/or polysilicon layers may be disposed on which conductive patterns of the interlayer insulating film 565 are formed, and the active devices may be connected to the conductive patterns via vertical contacts. Using these active elements, the monitoring circuits as will be described below may be formed and included in the heterogeneous semiconductor die HSD.

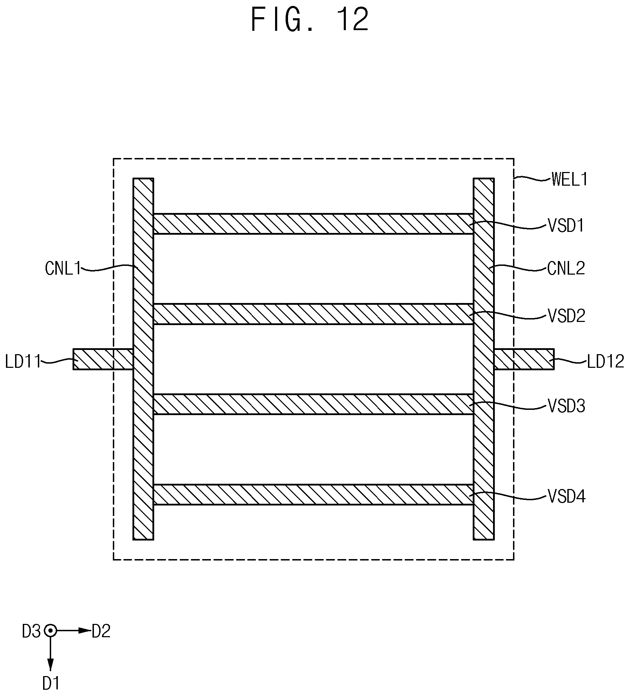

FIG. 12 is a diagram illustrating an example embodiment of an electrode conductor connecting capacitor electrodes of power capacitors included in a capacitor array.

FIG. 12 illustrates an example embodiment of the power electrode conductor WEL1 of FIG. 11. Referring to FIG. 12, the power electrode conductor WEL1 may include a plurality of row conductive patterns VSD1 through VSD4 arranged in the first horizontal direction D1 and extending in the second horizontal direction D2, and one or more column conductive patterns CNL1 and CNL2 arranged in the second horizontal direction D2 and extending in the first horizontal direction D1. The first capacitor electrodes 670 of the power capacitors CP of FIG. 11 may be connected to the row conductive patterns VSD1 through VSD4 via the contact plug structures 590, 600 and 610.

One or two voltage-applied conductive lines LD11 and LD12 may be connected to the column conductive lines CNL1 and CNL2, and the voltage-applied conductive lines LD11 and LD12 may be connected to a voltage node to which the power supply voltage VDD is applied.

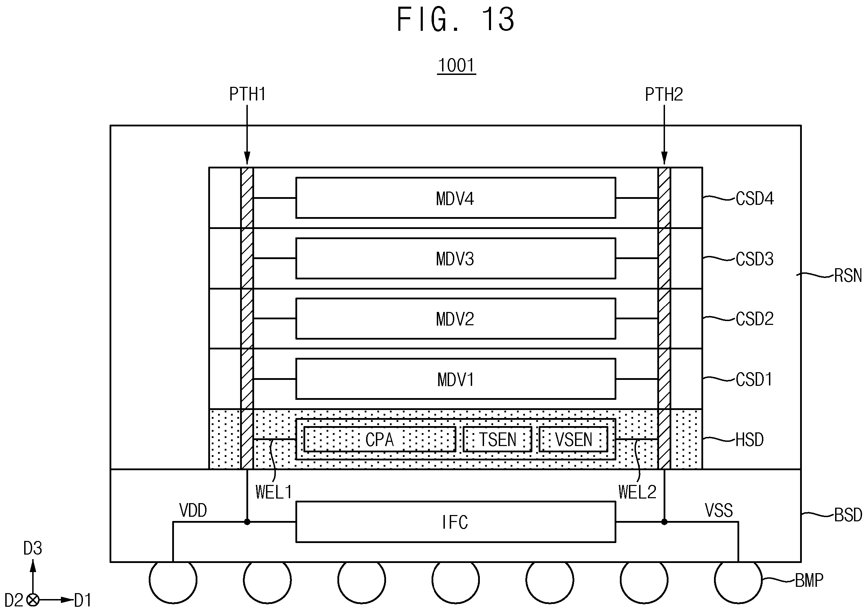

FIGS. 13, 14 and 15 are cross-sectional views illustrating a vertical structure of a semiconductor memory package according to one or more embodiments. Hereinafter, descriptions that are redundant with FIGS. 1 through 12 may be omitted.

Compared to the semiconductor memory package 1000 of FIG. 1, the heterogeneous semiconductor die HSD of a semiconductor memory package 1001 of FIG. 13 may further include monitoring circuits such as a temperature sensor TSEN and a voltage sensor VSEN. The temperature sensor TSEN may measure an internal temperature of the semiconductor memory package 1001, and the voltage sensor VSEN may measure an internal voltage of the semiconductor memory package 1001. As described with reference to FIG. 12, the monitoring circuits may be formed using active elements formed on the semiconductor substrate 500' and the interlayer insulating film 565. By placing the monitoring circuits in the heterogeneous semiconductor die HSD, the design margin of the core semiconductor die CSD1 through CSD4 and the buffer semiconductor die BSD may be further improved.

Compared to the semiconductor memory package 1000 of FIG. 1, the heterogeneous semiconductor die HSD of a semiconductor memory package 1002 of FIG. 14 may be stacked by bonding in the vertical direction D3 on the lower surface of the uppermost core semiconductor die CSD4 among the plurality of core semiconductor dies CSD1 through CSD4. The longer the voltage transmission path, the greater the resistive voltage drop, or ohmic drop, which may result in a lower voltage level of the power supply voltage VDD. By placing the capacitor array CPA at a location far from the source of the power supply voltage VDD, the reinforcement of the power supply voltage VDD may be realized more uniformly.

Compared to the semiconductor memory package 1000 of FIG. 1, the heterogeneous semiconductor die HSD of a semiconductor memory package 1003 of FIG. 15 may be embedded within a buffer semiconductor die BSD. The buffer semiconductor die BSD may include a top die SDu and a bottom die SDb, and the heterogeneous semiconductor die HSD may be embedded in one of the top die SDu and the bottom die SDb.

FIG. 15 illustrates an example embodiment in which a buffer semiconductor die BSD is embedded in the bottom die SDb. A support portion SPT may be disposed in the bottom die SDb. According to one or more embodiments, the horizontal dimensions in the first and second horizontal directions D1 and D2 of the heterogeneous semiconductor die HSD may be structurally implemented as a fan out structure with the same horizontal dimensions as the buffer semiconductor die BSD. In the case of the fan out structure, the support portion SPT may be omitted.

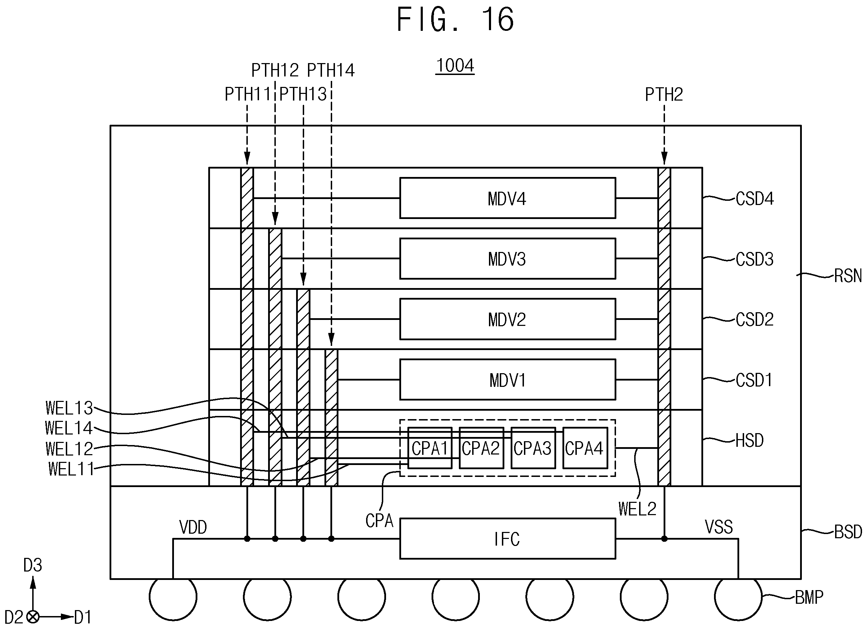

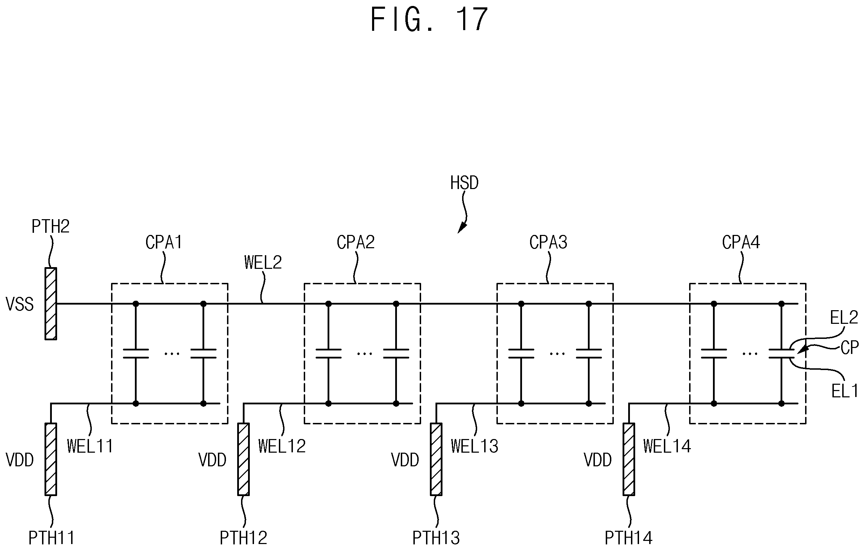

FIG. 16 is a cross-sectional view illustrating a vertical structure of a semiconductor memory package according to one or more embodiments, and FIG. 17 is a schematic diagram illustrating an example embodiment of a heterogeneous semiconductor die included in a semiconductor memory package according to one or more embodiments.

Referring to FIG. 16, a semiconductor memory package 1004 may include a buffer semiconductor die BSD, a plurality of core semiconductor dies CSD1 through CSD4, and a heterogeneous semiconductor die HSD. FIG. 16 illustrates, but is not limited to, an example in which four core semiconductor dies, i.e., first through fourth core semiconductor dies CSD1 through CSD4, are stacked for convenience of illustration and description. In one or more embodiments, the number of core semiconductor dies stacked in the semiconductor memory package 1004 may be varied.

External connection member, such as conductive bumps BMP, may be formed on the lower surface of the buffer semiconductor die BSD. The semiconductor dies BSD, HSD and CSD1 through CSD4 may be bonded and electrically connected to each other via bonding pads, microbumps, etc. Inside the core semiconductor dies CSD1 through CSD4, conductive paths such as through-silicon vias (TSV) that penetrate the semiconductor die, conductive patterns formed on the conductive layer, vertical contacts, and the like may be formed. The core semiconductor dies CSD1 through CSD4 may be electrically connected to each other via these conductive paths. The stacked semiconductor dies BSD, HSD and CSD1 through CSD4 may be packaged using sealing material RSN.

The buffer semiconductor die BSD may include an interface circuit IFC that performs communication with an external memory controller. The interface circuit IFC may include circuits for mediating communication between the core semiconductor dies CSD1 through CSD4 and the memory controller, such as circuits corresponding to a physical layer, command-address buffers, data buffers, clock buffers, and the like. The buffer semiconductor die BSD may further include various circuits, such as voltage regulators, power management integrated circuits (PMIC), and the like.

The plurality of core semiconductor dies CSD1 through CSD4 are stacked in the vertical direction D3 on the buffer semiconductor die BSD and include semiconductor memory devices MDV1 through MDV4, respectively. The semiconductor memory devices may include a plurality of memory cells. In an example embodiment, the plurality of memory cells may be dynamic random access memory (DRAM) cells such that each memory cell one cell capacitor and one cell transistor. One or more embodiments of the semiconductor memory device are the same as is described above with reference to FIGS. 5 through 10.

The heterogeneous semiconductor die HSD is stacked with the buffer semiconductor die BSD and the plurality of core semiconductor dies CSD1 through CSD4, and the heterogeneous semiconductor die HSD may include a capacitor array CPA. The capacitor array CPA may include a plurality of power capacitors and one or more electrode conductors (WEL11, WEL12, WEL13, WEL14, and WEL2) connecting electrodes of the plurality of power capacitors.

In an example embodiment, as shown in FIG. 16, the heterogeneous semiconductor die HSD may be bonded and stacked in the vertical direction D3 to the upper surface of the buffer semiconductor die BSD. In this configuration, by disposing the capacitor array CPA close to the buffer semiconductor die BSD, the voltage level of the power supply voltage VDD provided to the buffer semiconductor die BSD, which has relatively large power consumption, may be efficiently stabilized. As described above with reference to FIGS. 14 and 15, the position of the heterogeneous semiconductor die HSD in the stack of semiconductor dies may be varied.

Referring to FIGS. 16 and 17, a capacitor array CPA of the heterogeneous semiconductor die HSD may include a plurality of power capacitors CP. Each power capacitor CP may include a first capacitor electrode EL1 and a second capacitor electrode EL2. The plurality of power capacitors included in the capacitor array CPA may be divided into a plurality of capacitor groups CPA1 through CPA4.

The electrode conductors may include a plurality of power electrode conductors WEL11, WEL12, WEL13 and WEL14 and a ground electrode conductor WEL2.

The plurality of power electrode conductors WEL11, WEL12, WEL13 and WEL14 may be connected to a power node providing a power supply voltage VDD to the buffer semiconductor die BSD and the plurality of core semiconductor dies CSD1 through CSD4, and may be connected to first capacitor electrodes EL1 of power capacitors included in the plurality of capacitor groups CPA1 through CPA4, respectively, per capacitor group.

The ground electrode conductor WEL2 may be connected to a ground node that provides a ground voltage VSS to the buffer semiconductor die BSD and the plurality of core semiconductor dies CSD1 through CSD4, and the second capacitor electrodes EL2 of the plurality of power capacitors CP may be connected to each other.

The power supply voltage VDD and ground voltage VSS may be applied from the memory controller to the semiconductor memory package 1000 via the conductive bumps BMP.

As shown in FIG. 16, the power node providing the power supply voltage VDD may include a plurality of power vertical conductive paths PTH11 through PTH14 extending in the vertical direction D3, and the ground node providing the ground voltage VSS may include a ground vertical conductive path PTH2 extending in the vertical direction D3. Each of the plurality of power vertical conductive paths PTH11 through PTH14 and the ground vertical conductive path PTH2 may include through-silicon vias TSV formed inside the semiconductor die HSD and CSD1 through CSD4, and bonding pads included on the upper and lower surfaces of the semiconductor die HSD and CSD1 through CSD4. In one or more embodiments, the through-silicon vias TSV of the uppermost core semiconductor die CSD4 may be omitted.

As shown in FIGS. 16 and 17, the power supply voltage VDD may be provided to each of the plurality of core semiconductor dies CSD1 through CSD4 via a plurality of power vertical conductive paths PTH11 through PTH14 extending in the vertical direction D3, and the plurality of power electrode conductors WEL11, WEL12, WEL13 and WEL14 may be connected to each of the plurality of power vertical conductive paths PTH11 through PTH14 and the first capacitor electrodes EL1 of the power capacitors included in the plurality of capacitor groups CPA1 through CPA4, respectively, per capacitor group.

As shown in FIGS. 16 and 17, the ground voltage VSS is provided to the plurality of core semiconductor dies CSD1 through CSD4 via the ground vertical conductive path PTH2 extending in the vertical direction D3, and the ground electrode conductor WEL2 is connected to the vertical conductive path PTH2 and the second capacitor electrodes EL2 of the plurality of power capacitors CP included in the capacitor array CPA.

In one or more embodiments, the ground electrode conductor WEL2 and the ground vertical conductive path PTH2 may be omitted, and the second capacitor electrodes EL2 of the plurality of power capacitors CP may be floated.

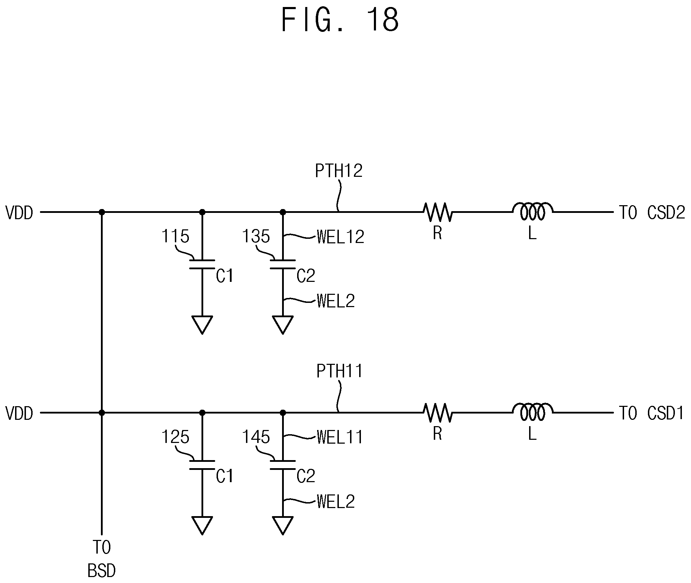

FIG. 18 is a diagram for describing a capacitance of a voltage node of a semiconductor memory package according to one or more embodiments.

FIG. 18 illustrates equivalent impedances along a transmission path of the power supply voltage VDD to the buffer semiconductor die BSD, the first core semiconductor die CSD1, and the second core semiconductor die CSD2. Referring to FIG. 18, the first capacitor group 145 may be connected to the transmission path PTH11 of the power supply voltage VDD of the first core semiconductor die CSD1 through the first power electrode conductor WEL11, and the second capacitor group 135 may be connected to the transmission path PTH12 of the power supply voltage VDD of the second core semiconductor die CSD1 through the second power electrode conductor WEL12. The first capacitor group 145 and the second capacitor group 135 may be connected to the ground node via the ground electrode conductor WEL2.

In this case, the first and second capacitor groups 145 and 135 are connected in parallel to the conventional capacitor groups 125 and 115, respectively, increasing the capacitance of the voltage node. As a result, the capacitances of the power supply voltage VDD transmission paths PTH11 and PTH12 are each equal to C1+C2, and the capacitance of the entire voltage node is 2 (C1+C2).

Conventionally, passive devices such as land-side capacitors (LSC) placed on the side of the base substrate on which the semiconductor memory package is stacked, and die-side capacitors (DSC) placed on the bottom side of the base substrate, have been used to increase the capacitance along the voltage transmission path. However, including such passive elements may increase the footprint of the semiconductor package and reduce design margins.

In one or more embodiments, voltage characteristics may be further improved by connecting additional passive devices, such as the LSC and the DSC, in addition to the power capacitors included in the heterogeneous semiconductor die HSD described with reference to FIGS. 1 through 18.

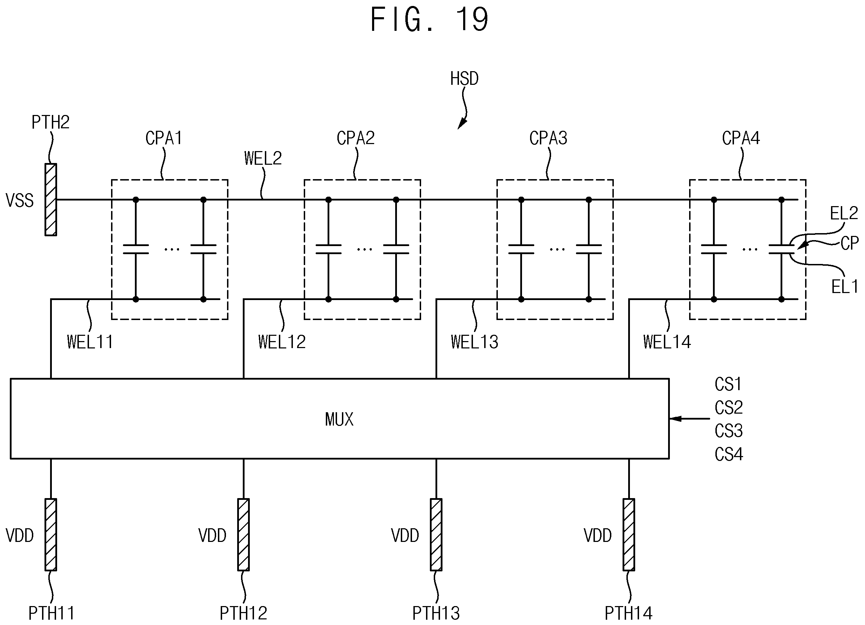

FIG. 19 is a diagram illustrating an example embodiment of a heterogeneous semiconductor die included in a semiconductor memory package according to one or more embodiments.

The heterogeneous semiconductor die HSD of FIG. 19 is similar to the heterogeneous semiconductor die HSD of FIG. 17, and thus repeated description is omitted. Referring to FIG. 19, the heterogeneous semiconductor die HSD may further include a multiplexer MUX that controls electrical connections between the plurality of power electrode conductors WEL11 through WEL14 and the plurality of vertical conductive paths PTH11 through PTH14.

As described above with reference to FIG. 4, the plurality of core semiconductor dies CSD1 through CSD4 may be selectively activated based on a plurality of chip selection signals CS1 through CS4 received from the memory controller.

As the power consumption of the plurality of core semiconductor dies CSD1 through CSD4 increases, the peak current increases and the voltage drop along the voltage transmission path increases, resulting in a ripple phenomenon that lowers the voltage level. When the plurality of core semiconductor dies CSD1 through CSD4 are active at the same time, it may be efficient to increase the capacitance evenly across the core semiconductor dies. However, if, for example, the plurality of core semiconductor dies CSD1 through CSD4 are memory semiconductor chips belonging to a single channel, the memory semiconductor chips may be selectively activated based on the corresponding respective chip selection signals. In this configuration, one memory semiconductor chip in the active state consumes a material amount of power while the remaining memory semiconductor chips in the idle state consume negligible power.

The multiplexer MUX may control the electrical connections between the plurality of power electrode conductors WEL11 through WEL14 and the plurality of vertical conductive paths PTH11 to PTH14 based on the plurality of chip selection signals CS1 through CS4.

For example, when the first chip selection signal CS1 is enabled and the second, third, and fourth chip signals CS2, CS3, and CS4 are disabled, the number of capacitor groups CPA1 through CPA4 of the plurality of capacitor groups connected to the voltage transfer path PTH11 that provides the power supply voltage VDD to the first core semiconductor die CSD1 may be increased.

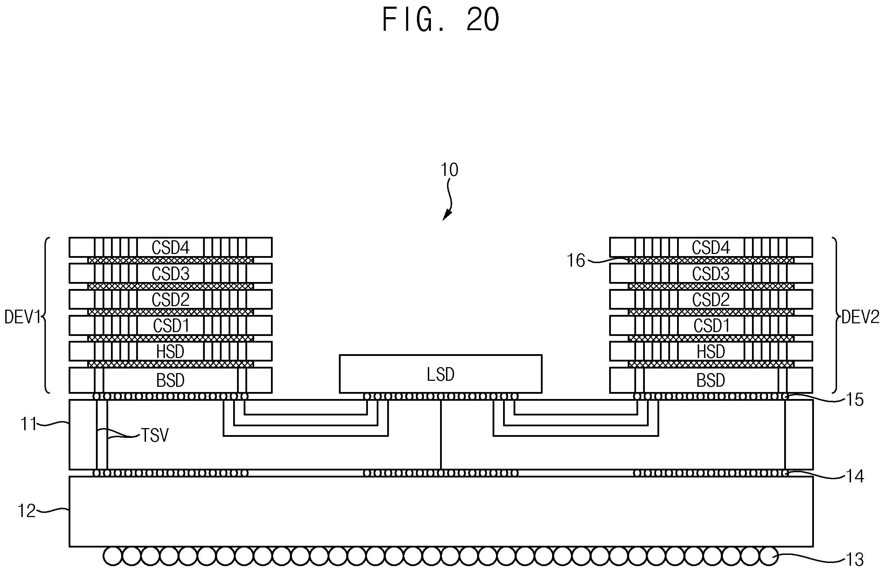

FIG. 20 is a diagram illustrating a stacked memory device according to one or more embodiments.

Referring to FIG. 20, the memory system may be implemented as a multi-chip package 10. The multi-chip package 10 includes a package substrate 12 and an interposer 11 mounted on the package substrate 12. The interposer 11 may be electrically coupled to the package substrate 12 via C4 bumps 14, pads, or any other conductive contact. The package substrate 12 may be connected to an external device via contact members 13 formed on the lower surface of the package substrate 12, such as balls in a ball grid array (BGA). The interposer 11 may include a metal layer forming conductive traces through-silicon via (TSV) and/or other conductive contacts or interconnections. Conductive interconnects within the interposer provide connections for devices mounted on the interposer 11 and/or conductive contacts on the package substrate 12. For example, the interposer 11 may include interconnects for connecting the logic die LSD to memory devices, such as HBM stacks DEV1 and DEV2. The interposer 11 may include an active device (e.g., a die that includes transistors or other active components) or a passive device (e.g., a die that does not include active components). In an example embodiment, the HBM stacks DEV1 and DEV2 are connected to the logic die LSD via a bridge die (e.g., an embedded multi-die interconnect bridge (EMIB)) or via another technique for combining chips in a multi-chip package. Although two HBM stacks DEV1 and DEV2 are shown, the multi-chip package 10 may include a single HBM stack or additional HBM stacks.

The multi-chip package includes the logic die LSD mounted on an interposer 11. The logic die may be or include system-on-chip (SoC), field-programmable gate array (FPGA), central processing unit (CPU), accelerator, graphics processing unit (GPU), or other logic die. The logic die LSD is coupled to the HBM stacks DEV1 and DEV2 via interconnects on the interposer 11, the EMIB, or other interconnects between the logic die LSD and the HBM stacks DEV1 and DEV2.

As shown in FIG. 20, the HBM stacks DEV1 and DEV2 include a buffer semiconductor die BSD and a plurality of memory semiconductor dies or a plurality of core semiconductor dies CSD1 through CSD4, wherein the buffer semiconductor die BSD and the plurality of core semiconductor dies CSD1 through CSD4 are electrically connected to each other via a plurality of vertical conductive paths including through-silicon vias TSV. Memory cells are distributed and disposed in the plurality of core semiconductor dies CSD1 through CSD4. The HBM stacks DEV1 and DEV2 may be internally and externally connected via contact means 15 and 16, e.g., microbumps.

According to one or more embodiments, each of the HBM stacks may include a heterogeneous semiconductor die HSD. As described above, the heterogeneous semiconductor die HSD is stacked with the buffer semiconductor die BSD and the plurality of core semiconductor dies CSD1 through CSD4, and includes a plurality of power capacitors.

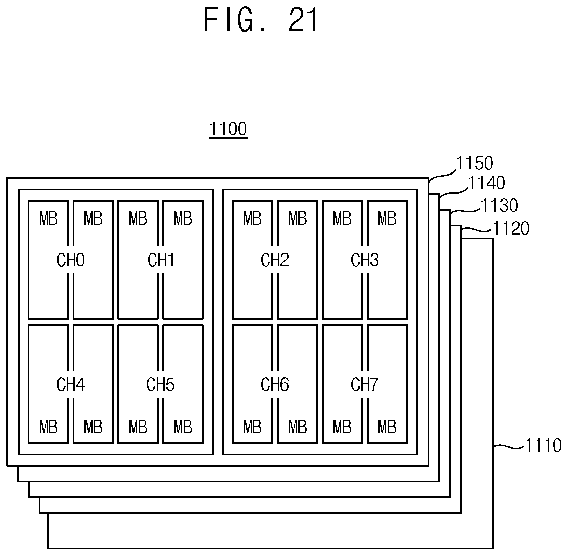

FIG. 21 is a diagram illustrating a stacked memory device according to one or more embodiments.

FIG. 21 illustrates an example of the structure of a high-bandwidth memory. Referring to FIG. 21, a high-bandwidth memory (HBM) 1100 may include a structure in which a plurality of semiconductor dies 1120, 1130, 1140 and 1150 are stacked. One of the plurality of semiconductor dies 1120, 1130, 1140 and 1150 may correspond to the heterogeneous semiconductor die and the others may correspond to the core semiconductor dies as described above. The core semiconductor dies may be referred to as DRAM semiconductor dies.

The high-bandwidth memory may be optimized for high-bandwidth operation of the stacked structure through a plurality of independent interfaces called channels. According to the HBM standard, each DRAM stack may support a variety of channels.

Although FIG. 21 illustrates an example in which four semiconductor dies are stacked, the disclosure is not limited thereto. Each semiconductor die may provide additional memory capacity and additional channels to the stacked structure. Each channel provides access to an independent set of DRAM banks. A request from one channel does not access data attached to another channel. The channels are independently clocked and do not need to be synchronized with each other. FIG. 21 illustrates an example in which the memory banks MB of each DRAM semiconductor die are grouped into eight independent channels CH0-CH7, but the disclosure is not limited thereto.

The high-bandwidth memory 1100 may include a buffer die or interface die 1110 located at the bottom of the stack structure and providing signal redistribution and other functions. Functions typically implemented in the DRAM semiconductor dies may be implemented in this interface die 1110.

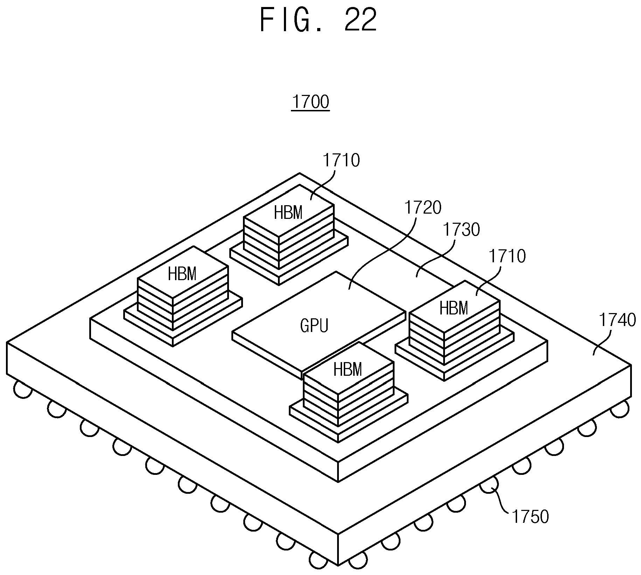

FIG. 22 is a diagram illustrating an example structure of a semiconductor package including a semiconductor memory device according to one or more embodiments.

Referring to FIG. 22, a semiconductor package 1700 includes one or more stacked memory devices 1710 and a graphics processing unit (GPU) 1720. The stacked memory devices 1710 and the GPU 1720 may be mounted on an interposer 1730, and the interposer 1730 on which the stacked memory devices 1710 and the GPU 1720 are mounted may be mounted on a package substrate 1740. Conductive bumps 1750 may be arranged on the bottom surface of the package substrate 1740. The GPU 1720 may perform substantially the same function as the aforementioned memory controller or may include a memory controller therein. The GPU 1720 may store data generated or used in graphic processing in one or more stacked memory devices 1710.

The stacked memory device 1710 may be implemented in various forms, and according to an example embodiment, the stacked memory device 1710 may be a memory device in the form of a high-bandwidth memory (HBM) in which a plurality of layers are stacked. Accordingly, the stacked memory device 1710 may include a buffer semiconductor die, a heterogeneous semiconductor die and a plurality of core semiconductor dies.

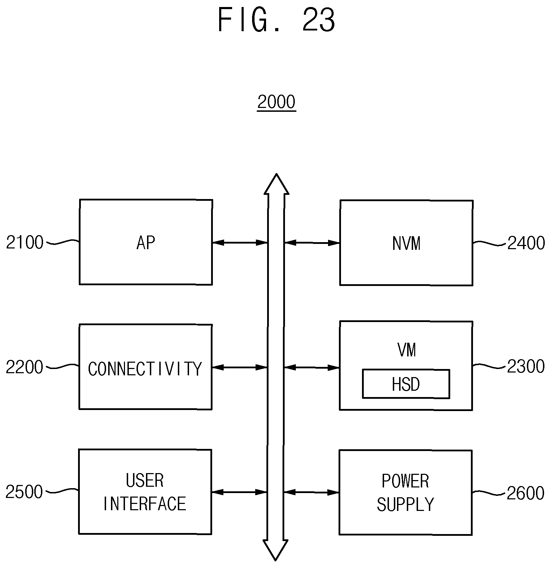

FIG. 23 is a block diagram illustrating a mobile system including a semiconductor memory device according to one or more embodiments.

Referring to FIG. 23, a mobile system 2000 includes an application processor 2100, a connectivity unit 2200, a semiconductor memory device 2300, a nonvolatile semiconductor memory device 2400, a user interface 2500 and a power supply 2600. According to one or more embodiments, the mobile system 2000 may be any mobile system, such as a mobile phone, a smart phone, a personal digital assistant (PDA), a portable multimedia player (PMP), a digital camera, a music player, a portable game console, a navigation system, etc. The application processor 2100 may execute applications that provide an Internet browser, a game, a video, etc. The connectivity unit 2200 may perform wireless or wired communication with an external device. The semiconductor memory device 2300 may store data processed by the application processor 2100 or may operate as a working memory.

The nonvolatile semiconductor memory device 2400 may store user data and a boot image for booting the mobile system 2000. The user interface 2500 may include one or more input devices such as a keypad, a touch screen, and/or one or more output devices such as a speaker, a display device. The power supply 2600 may supply an operation voltage of the mobile system 2000.

According to one or more embodiments, the semiconductor memory device 2300 may be implanted as a semiconductor memory package including a heterogeneous semiconductor die as described above.

As described above, the semiconductor memory package according to one or more embodiments may increase the capacitance of the voltage node and efficiently improve the voltage characteristics of the semiconductor memory package without increasing the occupied area of the semiconductor memory package by stacking the heterogeneous semiconductor die including the plurality of power capacitors together with the core semiconductor dies and by connecting the plurality of power capacitors to the voltage node.

Aspects of the present disclosure may be applied to any electronic devices and systems. For example, the disclosure may be applied to systems such as a memory card, a solid state drive (SSD), an embedded multimedia card (eMMC), a universal flash storage (UFS), a mobile phone, a smart phone, a personal digital assistant (PDA), a portable multimedia player (PMP), a digital camera, a camcorder, a personal computer (PC), a server computer, a workstation, a laptop computer, a digital TV, a set-top box, a portable game console, a navigation system, a wearable device, an internet of things (IoT) device, an internet of everything (IoE) device, an e-book, a virtual reality (VR) device, an augmented reality (AR) device, a server system, an automotive driving system, etc.

At least one of the components, elements, modules, units, or the like (collectively "components" in this paragraph) represented by a block or an equivalent indication (collectively "block") in the above embodiments including the drawings such as FIGS. 1, 4, 5, 13-16, and 19-23, for example, memory controller, control logic, address register, bank control logic, row address multiplexer, column address latch, row decoder, column decoder, core control circuit, input-output (I/O) gating circuit, memory cell array ,data input-output (I/O) buffer, and refresh counter, or the like, may carry out the above-described function or functions. These blocks may be physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure.

The foregoing is illustrative of one or more embodiments of the present disclosure and is not to be construed as limiting thereof. Although one or more embodiments have been described, those skilled in the art will readily appreciate that many modifications are possible in the example embodiments without materially departing from the present disclosure.

## Claims

1. A semiconductor memory package comprising:
a buffer semiconductor die comprising an interface circuit configured to perform communication with a memory controller;
a plurality of core semiconductor dies stacked in a vertical direction on the buffer semiconductor die, wherein a core semiconductor die of the plurality of core semiconductor dies comprises a semiconductor memory device; and
a heterogeneous semiconductor die stacked with the buffer semiconductor die and the plurality of core semiconductor dies,
wherein the heterogeneous semiconductor die comprises:
a capacitor array comprising a plurality of power capacitors; and
an electrode conductor connecting electrodes of the plurality of power capacitors.

2. The semiconductor memory package of claim 1,
wherein the electrode conductor comprises a power electrode conductor connected to a power node configured to provide a power supply voltage to the buffer semiconductor die and to the plurality of core semiconductor dies, and
wherein the power electrode conductor connects first capacitor electrodes of the plurality of power capacitors to each other.

3. The semiconductor memory package of claim 1,
wherein the electrode conductor comprises a ground electrode conductor connected to a ground node configured to provide a ground voltage to the buffer semiconductor die and to the plurality of core semiconductor dies, and
wherein the ground electrode conductor connects second capacitor electrodes of the plurality of power capacitors to each other.

4. The semiconductor memory package of claim 1, wherein a shape of each of the plurality of power capacitors is the same as a shape of a cell capacitor included in a memory cell of the semiconductor memory device.

5. The semiconductor memory package of claim 1, wherein the plurality of power capacitors are cylinder-shaped or pillar-shaped and are arranged repeatedly in a first horizontal direction and a second horizontal direction in an upper portion of a semiconductor substrate of the heterogeneous semiconductor die.

6. The semiconductor memory package of claim 1, wherein the heterogeneous semiconductor die is stacked on and adhered to an upper surface of the buffer semiconductor die in the vertical direction.

7. The semiconductor memory package of claim 1, wherein the heterogeneous semiconductor die is stacked on and adhered to a lower surface of an uppermost core semiconductor die, of the plurality of core semiconductor dies, in the vertical direction.

8. The semiconductor memory package of claim 1, wherein the heterogeneous semiconductor die is inside the buffer semiconductor die.

9. The semiconductor memory package of claim 1, further comprising:
a vertical conductive path extending in the vertical direction and configured to provide a power supply voltage to the plurality of core semiconductor dies,
wherein the electrode conductor comprises a power electrode conductor connected to the vertical conductive path, and
wherein the power electrode conductor connects first capacitor electrodes of the plurality of power capacitors to each other.

10. The semiconductor memory package of claim 1,
wherein the plurality of power capacitors are divided into a plurality of capacitor groups,
wherein the electrode conductor comprises a plurality of power electrode conductors, and
wherein each power electrode conductor connects first capacitor electrodes of power capacitors included in each of the plurality of capacitor groups.

11. The semiconductor memory package of claim 10, further comprising:
a plurality of power vertical conductive paths extending in the vertical direction and configured to respectively provide a power supply voltage to the plurality of core semiconductor dies.

12. The semiconductor memory package of claim 11, wherein the plurality of power electrode conductors are respectively connected to the plurality of power vertical conductive paths.

13. The semiconductor memory package of claim 11, further comprising:
a multiplexer configured to control connections between the plurality of power electrode conductors and the plurality of power vertical conductive paths.

14. The semiconductor memory package of claim 13,
wherein the plurality of core semiconductor dies are configured to be selectively activated based on a plurality of chip selection signals received from the memory controller, and
wherein the multiplexer is configured to control connections between the plurality of power electrode conductors and the plurality of power vertical conductive paths based on the plurality of chip selection signals.

15. The semiconductor memory package of claim 1, wherein the heterogeneous semiconductor die further comprises:
at least one of a temperature sensor configured to measure an internal temperature of the semiconductor memory package and a voltage sensor configured to measure an internal voltage of the semiconductor memory package.
